Europäisches Patentamt

(19) European Patent Office

Office européen des brevets

(11) Publication number : **0 208 851**
**B1**

(12) # EUROPEAN PATENT SPECIFICATION

(45) Date of publication of patent specification :
07.03.90

(51) Int. Cl.⁵ : **H 01 L 21/203**, H 01 J 37/30,
C 30 B 23/02

(21) Application number : 86105775.0

(22) Date of filing : 16.12.83

(60) Publication number of the earlier application in accordance with Art. 76 EPC : 0113983

(54) Fabricating a semiconductor device by means of molecular beam epitaxy.

(30) Priority : 28.12.82 JP 229708/82
16.12.82 JP 220663/82

(43) Date of publication of application :
21.01.87 Bulletin 87/04

(45) Publication of the grant of the patent :
07.03.90 Bulletin 90/10

(84) Designated contracting states :
DE FR GB

(56) References cited :
EP-A- 0 055 032
EP-A- 0 056 737
EP-A- 0 060 151
US-A- 4 058 413
IEEE SPECTRUM, vol. 17, no. 4, April 1980, pages 118-123, New York, US; M.G. PANISH et al.: "Molecular beam epitaxy"

(73) Proprietor : FUJITSU LIMITED
1015, Kamikodanaka Nakahara-ku
Kawasaki-shi Kanagawa 211 (JP)

(72) Inventor : Mimura, Takashi
1-10-42, Higashitamagawagakuen
Machida-shi Tokyo 194 (JP)
Inventor : Hikosaka, Kohki
Takefuji-so 205 59-2, Shiratoridai Midori-ku
Yokohama-shi Kanagawa 227 (JP)
Inventor : Odani, Kouichiro
1-408, 5, Araisono 4-chome
Sagamihara-shi Kanagawa 228 (JP)
Inventor : Ishikawa, Tomonori
2-9-44, Sakae-cho
Odawara-shi Kanagawa 250 (JP)
Inventor : Nishi, Hidetoshi
1-22-10, Chuorinkan
Yamamoto-shi Kanagawa 242 (JP)

(74) Representative : Greenstreet, Cyril Henry et al
Haseltine Lake & Co. Hazlitt House 28 Southampton
Buildings Chancery Lane
London WC2A 1AT (GB)

## Description

The present invention relates to fabricating a semiconductor device by means of molecular beam epitaxy (MBE).

In the fabrication of semiconductor devices, and in particular compound semiconductor devices, semiconductor layers with different widths of forbidden bands, conduction types, or carrier concentrations are often epitaxially grown on a semiconductor substrate to form a multilayer structure. This epitaxial growth may be effected by MBE, liquid phase epitaxy, vapor phase epitaxy, including organic-metal-pyrolysis vapor phase epitaxy, etc.

MBE allows precise control of the composition, the amount of doped impurity, and the growth rate of the semiconductor crystal layer, sharp change of the profile of the composition of a crystal layer or the amount of a doped impurity, for example a width of change of approximately 1 nm, and growth of a crystal layer with a composition different from one obtained in the state of chemical equilibrium, not possible with liquid phase epitaxy. MBE is therefore a preferred technique for forming a semiconductor crystal multilayer structure with extremely thin layers and very sharp changes of composition at the interfaces of the layers, as in a superlattice device.

Problems exist in the condition of the surface of a layer formed by MBE. In the conventional process for fabricating a semiconductor device, after the MBE is effected, the substrate and the crystal layer formed thereon by the MBE are cooled and then discharged from the MBE apparatus into the atmosphere before forming the semiconductor elements in and on the MBE layer.

In such a prior process, heat treatment after MBE may affect adversely the properties of an active region in MBE layers near the top surface. Such deterioration results from diffusion of an impurity into the active region. It is desirable to prevent this to maintain the excellent properties of the MBE layers.

For example, MBE is often used for the fabrication of heterojunction FET's. Here, MBE is used to form a nondoped GaAs layer and then a silicon-doped AlGaAs layer on a semi-insulating GaAs substrate. The interface of the GaAs layer and the AlGaAs layer is a heterojunction. An electron accumulating layer (two dimensional electron gas) is formed by displacement of electrons from the n-type AlGaAs layer (an electron supply layer) to the nondoped GaAs layer. If the electron sheet concentration of the electron storage layer is controlled by a voltage applied to a gate electrode formed on the n-type AlGaAs layer, the impedance of the conducting channel in the electron storage layer between a source electrode and a drain electrode is controlled. As a result, the device functions as a transistor.

To form ohmic contact regions of the source and drain electrodes of such a heterojunction-type FET, the following steps are often taken :

selectively implanting silicon ions into multiple n-type AlGaAs and nondoped GaAs layers ; forming a surface protective layer on the n-type AlGaAs layer ; and heating at 700 °C to 800 °C to activate the ion-implanted regions. This type of heat treatment lowers the electron mobility, however, for example, from approximately 110,000 $cm^2/V$. sec immediately after MBE to approximately 70,000 $cm^2/V$. sec after heat treatment at 700 °C for 15 minutes. The lowering of the electron mobility results from diffusion of silicon (Si) ions from the n-type AlGaAs layer into the nondoped GaAs layer. This lowering of the electron mobility by heat diffusion of an impurity is an important problem in that it negates the effect of providing a heterojunction interface for three dimensionally separating an impurity-doped layer for generating carriers and a channel layer.

It is desirable to prevent diffusion of impurities in a semiconductor layer formed by MBE.

The inventors have discovered that forming a protective layer such as an AlN layer on the surface of a crystal layer formed by MBE in the vacuum used in MBE prevents formation of an oxide layer at the surface of the MBE crystal layer due to exposure of the MBE layer to the atmosphere and dissociation of a component atom of the MBE crystal layer and formation of holes and other defects in the crystal during heat treatment of the MBE layer, which can prevent or decrease diffusion of an impurity in the MBE crystal layer. The inventors found that the lowering of the electron mobility of a heterojunction-type FET is greatly accelerated by a surface oxide layer of the MBE layer formed between MBE and formation of a protective layer for heat treatment in the prior art, and, therefore, deterioration of electrical properties such as lowering of the electron mobility is greatly decreased by preventing formation of a surface oxide layer of the MBE layer due to prevention of diffusion of an impurity. In carrying out the invention, a surface protective layer is formed without breaking the vacuum used in MBE.

According to the invention a method of manufacturing a semiconductor devices comprises the steps of forming a semiconductor layer on a semiconductor substrate in a vacuum by a molecular beam epitaxy process, transporting the coated substrate to a separate chamber and then subjecting it in vacuum in the said separate chamber to a covering process which causes a protective layer to be formed on the semiconductor layer, wherein the substrate is maintained under vacuum without any break thereof between the epitaxy and covering processes.

Advantageously the surface of the substrate is etched by hydrogen plasma etching before subjecting it to MBE, as described and claimed in EP-A-0 113 983, of which the present application is a divisional application. The hydrogen plasma etching may be used not only for cleaning the surface of a semiconductor substrate formed by MBE but also for selectively etching a semiconductor substrate to form an opening, a cavity, etc., before forming a semiconductor layer by MBE.

In the following description the invention is discussed in more detail, by way of example, in conjunction with such a preliminary hydrogen plasma etching step and with reference to the accompanying drawings in which :

Fig. 1 is a schematic view of apparatus for fabricating a semiconductor device, embodying the present invention ;

Fig. 2 is a perspective view of a wafer attached to a molybdenum (Mo) block ;

Figs. 3a to 3f are sectional views of an FET in the steps of fabrication ;

Figs. 4a to 4e are sectional views of an FET in the steps of fabrication ;

Fig. 5 is a graph of electron mobility against time of heat treatment ;

Fig. 6 is a graph of electron mobility against temperature of heat treatment ; and

Fig. 7 is a graph of concentration of electrons in an electron storage layer.

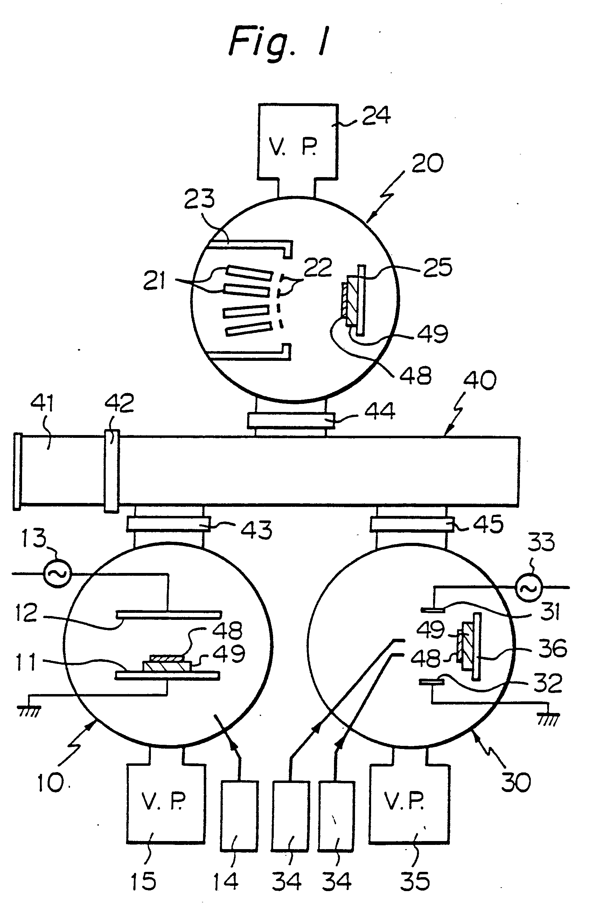

Figure 1 schematically illustrates apparatus for fabricating a semiconductor device embodying the present invention. The apparatus comprises three chambers 10, 20, and 30 for $H_2$ plasma etching, for MBE, and for forming a protective layer, usually an insulating layer, respectively.

The $H_2$ plasma etching chamber 10 comprises parallel plate-shaped electrodes 11 and 12 connected to a high frequency power source 13. An $H_2$ gas source 14 and a vacuum pump 15 are connected to the chamber 10.

The MBE chamber 20 comprises cells 21 of molecular beam sources. A shutter 22 is provided for each cell 21 to allow selection of the required molecular beam source. The cells 21 are surrounded by a shroud 23 cooled by liquid nitrogen. An extremely high vacuum pump 24 such as an ion pump or a cryo pump is connected to the MBE chamber 20.

The chamber 30 for forming an insulating layer is, in this case, a sputtering chamber. Alternatively, it may be a chemical vapor deposition (CVD) chamber. The sputtering chamber comprises electrodes 31 and 32 connected to a high frequency power source 33, a target (not shown in the figure) being set on one of the electrodes 31 and 32. Gas sources 34 and a vacuum pump 35 are connected to the sputtering chamber 30.

The three chambers 10, 20, and 30 are closed to maintain the vacuum and are communicated with each other through a section 40, the section 40 comprising a wafer-transporting mechanism also closed to maintain the vacuum. The wafer-transporting section 40 has a chamber 41 for mounting and removing wafers. A valve 42 is provided between the chamber 41 and a main chamber of the wafer-transporting section 40. Valves 43, 44, and 45 are provided between the wafer-transporting section 40 and the $H_2$ plasma etching chamber 10, the MBE chamber 20, and the sputtering chamber 30, respectively. Thus, a wafer 48 to be treated can be transported between the $H_2$ plasma etching chamber 10, the MBE chamber 20, and the sputtering chamber 30 respectively without breaking the vacuum state.

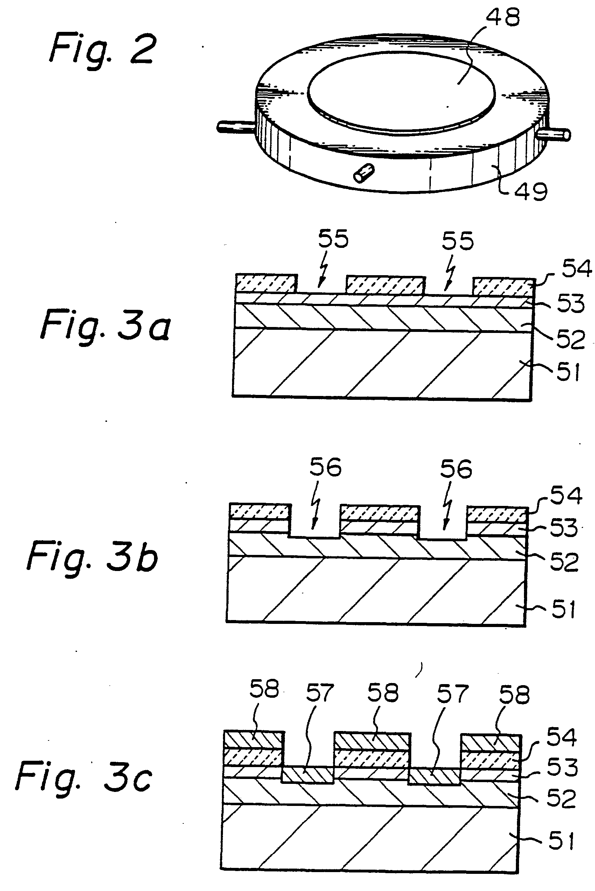

Referring to Fig. 2, a wafer 48 to be treated is bonded onto an Mo block 49. This Mo block 49 is mounted on the wafer-transporting mechanism, transported to each chamber 10, 20, or 30, and held on the electrode 11 or by a holder 25 or 36. The three chambers 10, 20, and 30 can be closed individually. Individual vacuum pumps 15, 24, and 35 do not necessarily have to be used, i. e., a single vacuum pump or two vacuum pumps may be used in place of the three vacuum pumps.

It will be understood that an embodiment of the present invention may incorporate any conventional $H_2$ plasma etching chamber, MBE chamber, insulating-layer formation chamber, and wafer-transporting means and that the apparatus is therefore not limited to that described above. Further, an embodiment of the present invention may involve only MBE and formation of an insulating layer and no $H_2$ plasma etching, therefore enabling simplification of the apparatus.

Below, an explanation will be given of a method of fabrication of heterojunction-type FET, embodying the present invention.

Referring to Fig. 3a, a nondoped GaAs layer 52 of, e. g., 600 nm and an n-type AlGaAs layer 53 of, e. g., 100 nm are continuously formed by MBE on a semi-insulating GaAs substrate 51. The n-type AlGaAs layer 53 is Si-doped at a dosage of, e. g., $1 \times 10^{18}$ cm$^{-3}$. A silicon dioxide (SiO$_2$) layer 54 of, e. g., 300 nm thickness is deposited onto the n-type AlGaAs layer 53 by a reactive sputtering process and selectively etched by a photolithography process to form windows 55 where source and drain regions are to be formed.

Referring to Fig. 3b, selective etching is conducted by using the SiO$_2$ layer 54 as a mask to form cavities 56 passing through the n-type AlGaAs layer 53 and a part of the nondoped GaAs layer 52, e. g., 300 nm thick. The wafer is then taken out of the etching chamber, resulting in contact with the atmosphere and, therefore, spontaneous formation of an oxide layer on the surface of the n-type AlGaAs layer 53 and the nondoped GaAs layer 52 in the cavity.

Referring to Figs. 1 and 3b, the wafer having the cavities 56 is then mounted in the wafer-transporting mechanism in the section 40, transported to the $H_2$ plasma-etching chamber 10, and fixed onto the electrode 11. The valve 43 is closed. The three chambers 10, 20, and 30 are evacuated by the vacuum pumps 15, 24, and 35. Hydrogen gas is fed to the $H_2$ plasma etching chamber 10 through a valve (not shown), the pressure in the chamber 10 being approximately 133 mPa ($10^{-3}$ Torr). A high frequency power of 100 V, 13.56 MHz is applied to generate $H_2$ plasma in the chamber 10 so that the exposed surfaces of the n-type AlGaAs layer 53 and the nondoped GaAs layer 52 in the cavities 56 are etched with the SiO$_2$ layer 54 acting as a mask. This etching completely removes the oxide layer at the surface in the cavities 56. The etching rate of $H_2$ plasma etching is not so high, but it is sufficient for use in practice.

After the $H_2$ supply is stopped, the chamber 10 is evacuated again to a vacuum of approximately $10^{-7}$ to $10^{-8}$ Torr and the valves 43 and 44 are opened so as to transport the wafer 48 into the MBE chamber 20. The wafer 48 is fixed to the holder 25 and the valve 44 is closed.

Referring to Fig. 1 and Fig. 3c, MBE is conducted to form source and drain regions 57 of $n^+$-type GaAs. In the MBE chamber 20 of, e. g., 13 nPa ($10^{-10}$ Torr), Ga, As, and Si molecular beams are applied from three cells 21 onto the wafer, while controlling the temperature in the chamber 20 and of the cells 21 and the wafer 48. Selectively, source gases may be supplied into the MBE chamber 20 from gas sources through pipes having valves (gas source, pipes, and valves not shown in figures). The dosage of Si in the $n^+$-type GaAs source and drain regions 57 is $1 \times 10^{18}$ $cm^{-3}$ to $2 \times 10^{18}$ $cm^{-3}$. Electron beam diffraction analysis confirms that the resultant $n^+$-type GaAs source and drain regions 57 are of complete single crystal and that an $n^+$-type amorphous layer 58 is formed on the surface of the $SiO_2$ layer 54.

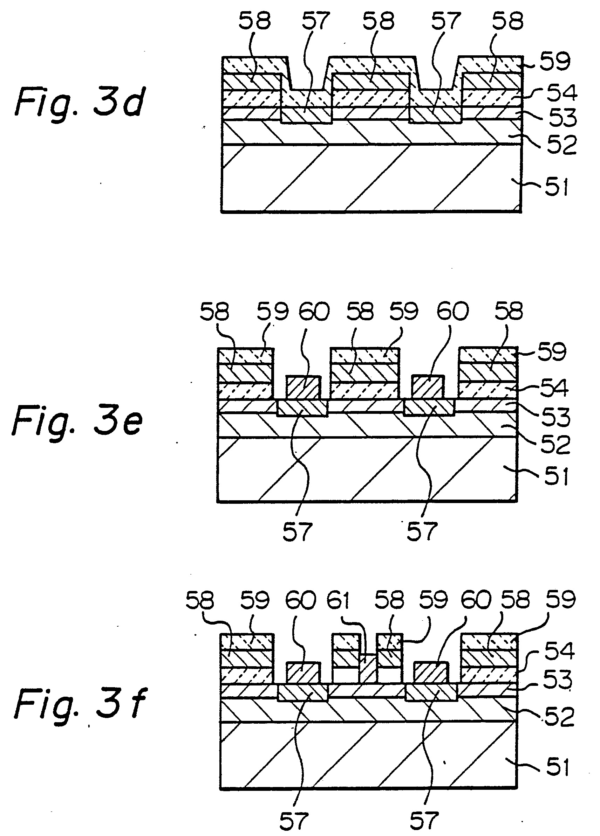

Referring to Fig. 1 and Fig. 3d, the MBE chamber 20 is evacuated again to clean it. The valve 44 is opened and the wafer 48 is transported to the insulating-layer formation chamber 30 in which the wafer 48 is fixed to the holder 36. The valve 45 is closed. An insulating layer 59 of silicon nitride ($Si_3N_4$) is formed on the entire surface as a protective layer. For example, a target of silicon is placed in the chamber 30 and nitrogen ($N_2$) gas is fed to the chamber 30 from a gas source 34. A high frequency of, e. g., 13.56 MHz is applied at 133 mPa ($10^{-3}$ Torr) so that Ar ions are accelerated to sputter the target, depositing an $Si_3N_4$ layer on the wafer 48.

The wafer 48 is then taken out of the apparatus in Fig. 1. Referring to Fig. 3e, source- and drain-electrode contact windows are opened, then source and drain electrodes 60 are formed by depositing and then patterning gold-germanium/gold (Au · Ge/Au) layers.

Referring to Fig. 3f, a gate-electrode contact window is opened, then a gate electrode is formed by depositing and then patterning a Schottky electrode metal layer such as aluminum (Al) or titanium/platinum/gold (Ti/Pt/Au). These processes for forming electrodes 60 and 61 are conventional.

While the above explanation has the cavities 56 formed by a separate etching apparatus, they may be formed by $H_2$ plasma etching in the chamber 10 of the apparatus in Fig. 1. In such a case, after etching, the wafer 48 can be transported directly to the MBE chamber 20 to form source and drain regions 57 by MBE, since no surface oxide layer is formed.

Below, an explanation will be given of the fabrication of a heterojunction-type FET wherein the source and drain contact regions are formed by ion implantation. In this case, the problem of cleaning is not considered. Only the problem of the condition of the surface of the semiconductor layer formed by MBE is considered, so an apparatus without a chamber 10 for $H_2$ plasma etching may be used.

Referring to Fig. 1 and Fig. 4a, a wafer 48, i. e., a semi-insulating GaAs substrate 80, is fixed to the holder 25, and the chamber 20 for MBE is evacuated to, e. g., 13 nPa ($10^{-10}$ Torr). Onto the substrate 80, a nondoped GaAs layer 81 of 1 $\mu m$ thickness and an n-type AlGaAs layer 82 of $1 \times 10^{18}$ $cm^{-3}$ Si dosage and 100 nm thickness are formed by MBE. An electron accumulating layer is spontaneously formed in the nondoped GaAs layer 81 near the interface to the n-type AlGaAs layer 82.

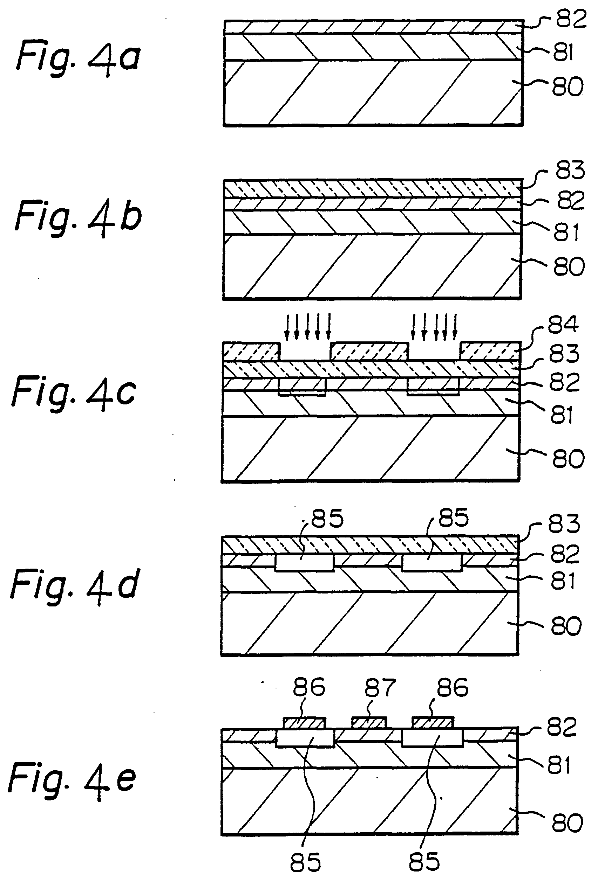

Referring to Fig. 1 and Fig. 4b, the wafer 48 is transported to the sputtering chamber 30 and fixed to the holder 36, the chamber 30 being evacuated to, e. g., 13 nPa ($10^{-10}$ Torr), similar to that of the MBE chamber 20. For example, the electrode 31 has an Al target, and $N_2$ gas and Ar gas are fed into the sputtering chamber 30 from the gas sources. A high frequency power of 13.56 MHz and 500 W is applied between the electrodes 31 and 32. Thus, reactive sputtering is effected to form an aluminum nitride (AlN) layer 83 of, e. g., 100 to 300 nm on the surface of the n-type AlGaAs layer 82. Selectively, the protective layer may be, for example, of $SiO_2$ or $Si_3N_4$. The wafer is removed from the apparatus in Fig. 1.

Referring to Fig. 4c, a mask 84 is formed by depositing an $SiO_2$ layer and then patterning it. By using the mask 84, Si ions are selectively implanted through the AlN layer 83 into the n-type AlGaAs layer 82 at 100 kV and $1 \times 10^{13}$ $cm^{-2}$.

Referring to Fig. 4d, the mask 84 of $SiO_2$ is removed, for example, by hydrofluoric acid. Heat treatment is conducted, e. g., at 750 °C for 15 minutes to activate the Si ions, forming $n^+$-type source and drain regions 85 of a carrier concentration of approximately $3 \times 10^{17}$ $cm^{-3}$.

Referring to Fig. 4e, the AlN layer 83 is removed by, e. g., heated phosphoric acid. Source and drain electrodes 86 of, e. g., Au · Ge/Au are formed on the $n^+$-type regions 85. A gate electrode 87 is formed of, e. g., Ti/Pt/Au.

In the resultant heterojunction-type FET, the electron accumulating layer has an electron concentration of approximately $5.7 \times 10^{11}$ $cm^{-3}$ and an electron mobility of approximately 100,000 $cm^2/V$ sec. In a corresponding prior FET, the electron accumulating layer had an electron concentration of approximately $6.1 \times 10^{11}$ $cm^{-2}$ and an electron mobility of approximately 70,000 $cm^2/V$ sec. In such a FET, a protective layer of AlN is formed after the wafer is removed from an MBE apparatus. The original electron concentration and electron mobility of the electron accumulating layer just after MBE are approximately $5.6 \times 10^{11}$ $cm^{-3}$ and approximately 110,000 $cm^2/V$ sec, respectively. It is clear that the deterioration of the electron accumulating layer can be decreased in embodiments of the invention.

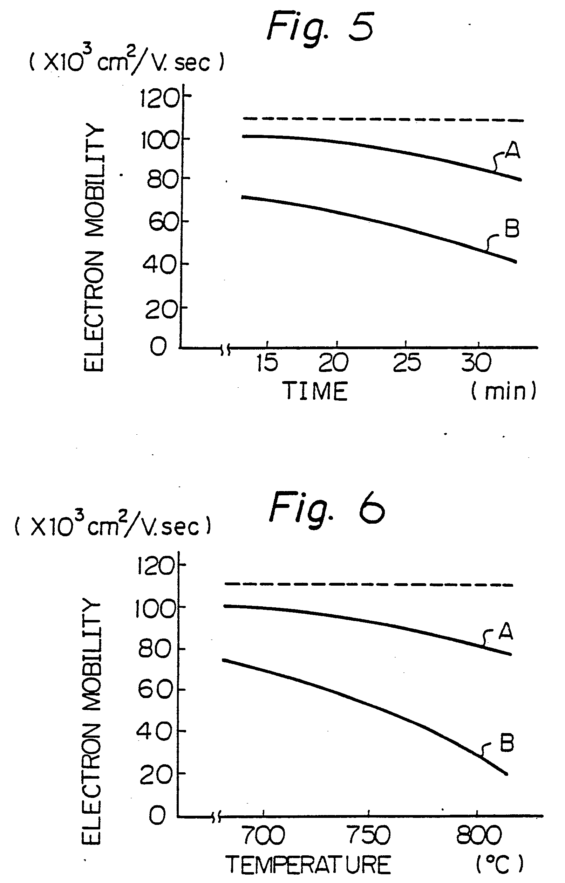

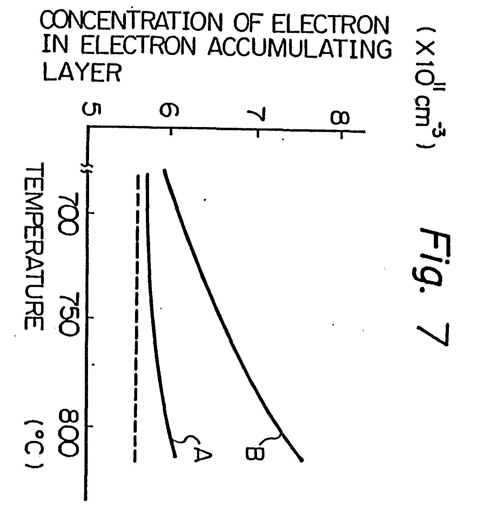

The effects of conditions of heat treatment on electron mobility of heterojunction-type FET's fabricated according to a procedure similar to the above were studied. First, the heat treatment was conducted at approximately 700 °C for various time periods. The results are summarized in Fig. 5, in which line A denotes FET's made using methods embodying the invention and line B those of prior methods. Second, the heat treatment was conducted for 15 minutes at various temperatures. The results are summarized in Figs. 6 and 7, in which lines A and B correspond to the FET's of line A and line B in Fig. 5 respectively.

From these results, the present inventors found that, for all times and temperatures of heat treatment, the decline of the electron mobility in a heterojunction-type FET is greatly accelerated by a surface oxide layer formed between the steps of MBE and forming a protective layer and that, therefore, deterioration of electrical characteristics such as electron mobility can be greatly decreased by preventing formation of a surface oxide layer of a semiconductor layer formed by MBE.

While the above explanations concerned heterojunction-type FET's, embodiments of the invention may also be used for other semiconductor devices. It is known that MBE is often used in other semiconductor devices such as semiconductor lasers and photodiodes and that ion implantation is often used for forming, for example, regions of different conduction types in a layer formed by MBE in a semiconductor device.

Since known photodiodes and photolasers have, in general, a thicker cap layer on an active layer than that of a heterojunction-type FET, a surface oxide layer has little effect on the active layer. However, leakage current in a photodiode, etc. is increased by oxidation of the surface of a semiconductor substrate, which can be prevented in embodiments of the present invention. Further, in a reach-through type avalanche photodiode (APD) in which a buried layer of a high impurity concentration is formed in a multiplication layer of the APD, an embodiment of the invention may be applied for a process comprising ion implantation of an impurity into a first epitaxial layer followed by growth of a second epitaxial layer. As a result, deterioration of the APD is decreased due to the prevention of formation of an oxide layer at the interface of the first and second epitaxial layers.

According to an embodiment of the invention, formation of a surface oxide layer at the surface of a grown crystal layer is prevented, resulting in decreased diffusion of an impurity in the crystal layers during subsequent heat treatment in a process for fabricating a semiconductor device.

## Claims

1. A method of manufacturing a semiconductor device comprising the steps of forming a semiconductor layer on a semiconductor substrate in a vacuum by a molecular beam epitaxy process, transporting the coated substrate to a separate chamber and then subjecting it in vacuum in the said separate chamber to a covering process which causes a protective layer to be formed on the semiconductor layer, wherein the substrate is maintained under vacuum without any break thereof between the epitaxy and covering processes.

2. A method as claimed in claim 1 which comprises the steps of subjecting a semiconductor substrate to a vacuum and then transporting it to successive stations in separate chambers where it is subjected under vacuum to a molecular beam epitaxy process to form a semiconductor layer on the substrate and then to a process which causes a protective layer to be formed on the semiconductor layer, all without breaking the vacuum.

3. A method as claimed in claim 1 or claim 2, wherein after the formation of the protective layer the semiconductor layer and protective layer are together subjected to heat treatment.

4. A method as claimed in any preceding claim, wherein the protective layer is an insulating layer.

5. A method as claimed in any preceding claim, wherein the protective layer consists of AlN, $SiO_2$ or $Si_3N_4$.

6. A method as claimed in any preceding claim, wherein the protective layer is formed by sputtering or by a chemical vapour deposition (CVD) process.

7. A method as claimed in any preceding claim, wherein the semiconductor layer consists of a compound semiconductor.

8. A method as claimed in any preceding claim, wherein the semiconductor layer consists of GaAs.

9. A method as claimed in any preceding claim, wherein at least part of the substrate consists of a compound semiconductor.

10. A method as claimed in any preceding claim, wherein at least part of the substrate consists of AlGaAs.

11. Apparatus for use in manufacturing a semiconductor device, comprising :

a first vacuum chamber (20) containing means whereby a semiconductor substrate (48) can be subjected to a molecular beam epitaxy process to form a semiconductor layer on such substrate ;

a second vacuum chamber (30) containing means whereby such substrate can be subjected to a process for forming a protective layer on the semiconductor layer formed by such epitaxy process ;

vacuum pump means (VP) for establishing a vacuum in each vacuum chamber ; and

transfer means (40) defining a vacuum-tight passageway, between the two vacuum chambers, and including conveying apparatus whereby such semiconductor substrate can be moved from the said first vacuum chamber to the said second vacuum chamber whilst being maintained continuously under vacuum.

12. Apparatus as claimed in claim 11, wherein the protective layer forming means comprise sputtering apparatus.

13. Apparatus as claimed in claim 11, wherein the protective layer forming means comprise chemical vapour deposition (CVD) apparatus.

14. Apparatus as claimed in any one of claims 11 to 13, further comprising a gas supply (34) connected for supplying a working gas to the said second vacuum chamber.

15. Apparatus as claimed in any one of claims 11 to 14, wherein the said transfer means are connected to each vacuum chamber by way of a valve.

16. Apparatus as claimed in any one of claims 11 to 15, wherein the vacuum pump means comprise an ion pump or a cryo pump.

17. Apparatus as claimed in any one of claims 11 to 16, wherein the vacuum pump means comprise individual vacuum pumps (24, 35) connected respectively to the vacuum chambers.

**Patentansprüche**

1. Verfahren zur Herstellung einer Halbleitervorrichtung mit den Schritten : Bilden einer Halbleiterschicht auf einem Halbleitersubstrat in einem Vakuum durch ein Molekularstrahl-Epitaxieverfahren, Transportieren des überzogenen Substrates zu einer separaten Kammer und dann Unterwerfen desselben im Vakuum in der genannten separaten Kammer unter ein Bedeckungsverfahren, das bewirkt, daß eine Schutzschicht auf der Halbleiterschicht gebildet wird, wobei das Substrat unter Vakuum ohne eine Unterbrechung desselben zwischen dem Epitaxie- und dem Bedeckungsverfahren aufrechterhalten wird.

2. Verfahren nach Anspruch 1, welches die Schritte des Unterwerfens eines Halbleitersubstrats unter ein Vakuum und dann Transportieren desselben zu aufeinanderfolgenden Stationen in separaten Kammern umfaßt, wobei es unter Vakuum einem Molekularstrahl-Epitaxieverfahren ausgesetzt wird, um eine Halbleiterschicht auf dem Substrat zu bilden, und dann einem Verfahren, welches bewirkt, daß eine Schutzschicht auf der Halbleiterschicht gebildet wird, alles ohne Unterbrechung des Vakuums.

3. Verfahren nach Anspruch 1 oder 2, bei dem nach Bilden der Schutzschicht die Halbleiterschicht und die Schutzschicht zusammen einer Wärmebehandlung unterworfen werden.

4. Verfahren nach einem der vorhergehenden Ansprüche, bei dem die Schutzschicht eine isolierende Schicht ist.

5. Verfahren nach einem der vorhergehenden Ansprüche, bei dem die Schutzschicht aus AlN, $SiO_2$ oder $Si_3N_4$ besteht.

6. Verfahren nach einem der vorhergehenden Ansprüche, bei dem die Schutzschicht durch Zerstäuben oder durch ein chemisches Dampfabscheidungsverfahren (CVD) durchgeführt wird.

7. Verfahren nach einem der vorhergehenden Ansprüche, bei dem die Halbleiterschicht aus einem Verbindungshalbleiter besteht.

8. Verfahren nach einem der vorhergehenden Ansprüche, bei dem die Halbleiterschicht aus GaAs besteht.

9. Verfahren nach einem der vorhergehenden Ansprüche, bei dem wenigstens ein Teil des Substrats aus einem Verbindungshalbleiter besteht.

10. Verfahren nach einem der vorhergehenden Ansprüche, bei dem wenigstens ein Teil des Substrats aus AlGaAs besteht.

11. Vorrichtung zur Verwendung bei der Herstellung einer Halbleitervorrichtung, mit :

einer ersten Vakuumkammer (20), die Einrichtungen enthält, durch welche ein Halbleitersubstrat (48) einem Molekularstrahl-Epitaxieverfahren unterworfen werden kann, um eine Halbleiterschicht auf solch einem Substrat zu bilden ;

eine zweite Vakuumkammer (30), die Einrichtungen enthält, durch welche solch ein Substrat einem Verfahren zur Bildung einer Schutzschicht auf der Halbleiterschicht, die durch solch ein Epitaxieverfahren gebildet worden ist, unterworfen werden kann ;

einer Vakuumpumpeneinrichtung (VP) zur Herstellung eines Vakuums in jeder Vakuumkammer ; und

Transfereinrichtungen (40), welche einen vakuumdichten Durchgang zwischen den beiden Vakuumkammern begrenzen und eine Fördervorrichtung enthalten, wodurch solch ein Halbleitersubstrat von der genannten ersten Vakuumkammer zu der genannten zweiten Vakuumkammer transportiert werden kann, während es kontinuierlich unter Vakuum gehalten wird.

12. Vorrichtung nach Anspruch 11, bei der die Schutzschichtbildungseinrichtung eine Zerstäubungsvorrichtung umfaßt.

13. Vorrichtung nach Anspruch 11, bei der die Schutzschichtbildungseinrichtung eine Vorrichtung für die chemische Dampfabscheidung (CVD) umfaßt.

14. Vorrichtung nach einem der Ansprüche 11 bis 13, ferner mit einer Gasversorgung (34), die angeschlossen ist, um ein Arbeitsgas zu der genannten zweiten Vakuumkammer zu liefern.

15. Vorrichtung nach einem der Ansprüche 11 bis 14, bei der die genannten Transfereinrichtungen mit jeder Vakuumkammer über ein Ventil verbunden sind.

16. Vorrichtung nach einem der Ansprüche 11 bis 15, bei der die Vakuumpumpeneinrichtung eine Ionenpumpe oder eine Cryopumpe umfaßt.

17. Vorrichtung nach einem der Ansprüche 11 bis 16, bei der die genannte Vakuumpumpeneinrichtung individuelle Vakuumpumpen (24, 35) umfaßt, die jeweils mit den Vakuumkammern verbunden sind.

**Revendications**

1. Procédé de fabrication d'un dispositif semiconducteur, comprenant les opérations consistant à former une couche semiconductrice sur un substrat semi conducteur, sous vide, à l'aide d'un processus d'épitaxie par faisceau moléculaire, à transporter le substrat ayant subi ce dépôt jusqu'à une chambre séparée, puis à le soumettre, sous vide, dans ladite chambre séparée à un processus de revêtement qui amène la formation d'une couche protectrice sur la couche semiconductrice, où le substrat est maintenu sous vide, sans aucune interruption de celui-ci, entre les processus d'épitaxie et de revêtement.

2. Procédé selon la revendication 1, qui comprend les opérations consistant à soumettre un substrat semi conducteur à un certain vide, puis à le transporter jusqu'à des postes successifs se trouvant dans des chambres séparées, où il est soumis, sous vide, à un processus d'épitaxie par faisceau moléculaire visant à former une couche semiconductrice sur le substrat, puis à un processus qui amène la formation d'une couche protectrice sur la couche semiconductrice, tout cela sans interrompre l'application du vide.

3. Procédé selon la revendication 1 ou 2, où, après la formation de la couche protectrice, on soumet ensemble à un traitement thermique la couche semiconductrice et la couche protectrice.

4. Procédé selon l'une quelconque des revendications précédentes, où la couche protectrice est une couche isolante.

5. Procédé selon l'une quelconque des revendications précédentes, où la couche protectrice est constituée de AlN, $SiO_2$ ou $Si_3N_4$.

6. Procédé selon l'une quelconque des revendications précédentes, où la couche protectrice est formée par pulvérisation ou par dépôt chimique sous forme vapeur (CVD).

7. Procédé selon l'une quelconque des revendications précédentes, où la couche semiconductrice est constituée d'un semiconducteur composé.

8. Procédé selon l'une quelconque des revendications précédentes, où la couche semiconductrice est constituée de GaAs.

9. Procédé selon l'une quelconque des revendications précédentes, où au moins une partie du substrat est constituée d'un semiconducteur composé.

10. Procédé selon l'une quelconque des revendications précédentes, où au moins une partie du substrat est constituée de AlGaAs.

11. Appareil destiné à être utilisé pour la fabrication d'un dispositif semiconducteur, comprenant :

une première chambre à vide (20) contenant des moyens par lesquels un substrat semiconducteur (48) peut être soumis à un processus d'épitaxie par faisceau moléculaire visant à former une couche semiconductrice sur ce substrat ;

une deuxième chambre à vide (30) contenant des moyens par lesquels ce substrat peut être soumis à un processus de formation d'une couche protectrice sur la couche semiconductrice formée par le processus d'épitaxie ;

une pompe à vide (VP) servant à établir un certain vide dans chaque chambre à vide ; et

un moyen de transfert (40) définissant un passage hermétiquement fermé et maintenu sous vide, entre les deux chambres à vide, et comportant un appareil de transport, si bien que ledit substrat semiconducteur peut être déplacé de ladite première chambre à vide à ladite deuxième chambre à vide tout en étant maintenu continûment sous vide.

12. Appareil selon la revendication 11, où le moyen formant la couche protectrice comprend un appareil de pulvérisation.

13. Appareil selon la revendication 11, où le moyen de formation de couche protectrice comprend un appareil de dépôt chimique sous forme vapeur (CVD).

14. Appareil selon l'une quelconque des revendications 11 à 13, comprenant en outre une alimentation en gaz (34) raccordée de façon à délivrer un gaz de travail à ladite deuxième chambre à vide.

15. Appareil selon l'une quelconque des revendications 11 à 14, où ledit moyen de transfert est raccordé à chaque chambre à vide par l'intermédiaire d'une vanne.

16. Appareil selon l'une quelconque des revendications 11 à 15, où la pompe à vide comprend une pompe ionique ou une pompe cryo.

17. Appareil selon l'une quelconque des revendications 11 à 16, où la pompe à vide comprend des pompes à vide distinctes (24, 35) respectivement raccordées aux chambres à vide.

# Fig. 1

*Fig. 2*

48

49

*Fig. 3a*

55     55

54
53
52
51

*Fig. 3b*

56     56

54
53
52

51

*Fig. 3c*

58   57   58   57   58

54
53
52

51

2

Fig. 3d

Fig. 3e

Fig. 3f

Fig. 4a

Fig. 4b

Fig. 4c

Fig. 4d

Fig. 4e

# Fig. 5

( $\times 10^3$ cm$^2$/V. sec )

# Fig. 6

( $\times 10^3$ cm$^2$/V.sec )

Fig. 7